# EUROPEAN PATENT SPECIFICATION

(11) **EP 4 573 528 B1**
(45) Date of publication and mention of the grant of the patent: **21.10.2026**
(21) Application number: 23855506.4
(22) Date of filing: 18.08.2023
(51) Int. Cl.: G06V 20/64, G06T 7/30, G06T 17/00, G06F 30/20, G06T 7/33, G06T 17/20, G06V 10/75, G06V 10/74

(54) **FAST FEATURE RECOGNITION AND MESH GENERATION IN STRUCTURAL DESIGN**
SCHNELLE MERKMALSERKENNUNG UND MASCHENERZEUGUNG IN STRUKTURDESIGN
RECONNAISSANCE RAPIDE DE CARACTÉRISTIQUES ET GÉNÉRATION DE MAILLAGE DANS UNE CONCEPTION STRUCTURALE

(30) Priority: 19.08.2022 US 202263399351 P; 09.11.2022 US 202217984210
(43) Date of publication of application: 25.06.2025
(73) Proprietor: Fluid Dynamic Sciences, LLC, Fort Worth, TX 76118 (US)
(72) Inventor: STANDINGFORD, David, Chepstow (GB); APPA, Jamil, Bristol BS7 8LY (GB); SHARPE, James, Bath, BA2 1NL (GB); ZHANG, Wenhao, Bristol Robotics Lab. UWE, T Block, Frenchay Campus, Coldharbour Lane Bristol BS16 1QY (GB)
(74) Representative: Murgitroyd & Company
(86) International application number: PCT/US2023/030585
(87) International publication number: WO 2024/039852

(56) References cited:
- US-A1- 2019 035 150
- US-A1- 2019 319 851
- US-A1- 2020 342 614
- US-A1- 2021 027 532
- ZHAO HENGWANG ET AL: "CentroidReg: A Global-to-Local Framework for Partial Point Cloud Registration", IEEE ROBOTICS AND AUTOMATION LETTERS, IEEE, vol. 6, no. 2, 23 February 2021 (2021-02-23), pages 2533 - 2540, XP011844297, DOI: 10.1109/LRA.2021.3061369
- BEN ADALLAH HAMDI ET AL: "3D point cloud analysis for automatic inspection of aeronautical mechanical assemblies", SPIE PROCEEDINGS; [PROCEEDINGS OF SPIE ISSN 0277-786X], SPIE, US, vol. 11172, 16 July 2019 (2019-07-16), pages 111720U - 111720U, XP060124909, ISBN: 978-1-5106-3673-6, DOI: 10.1117/12.2521715
- WU BINGLI; MA JIE; CHEN GAOJIE; AN PEI: "Feature Interactive Representation for Point Cloud Registration", 2021 IEEE/CVF INTERNATIONAL CONFERENCE ON COMPUTER VISION (ICCV), IEEE, 10 October 2021 (2021-10-10), pages 5510 - 5519, XP034093701, DOI: 10.1109/ICCV48922.2021.00548

## Description

### COPYRIGHT

A portion of the disclosure of this patent document contains material which is subject to copyright protection. The copyright owner has no objection to the facsimile reproduction by anyone of the patent document or the patent disclosure, as it appears in the Patent and Trademark Office patent file or records, but otherwise reserves all copyright rights whatsoever.

### CROSS-REFERENCE TO RELATED APPLICATIONS

This application claims the benefit of U.S. Provisional Application No. 63/399,351, filed August 19, 2022.

### BACKGROUND

The present invention relates to computational engineering technology, and more particularly to technology for recognizing features within a computationally designed structure.

Computational engineering analysis processes typically apply an algorithm to a digital representation of a Product. For example in computational fluid dynamics, a mesh is generated that represents the shape of the product and forms a basis for the flow features around the product. As is known in the art, a mesh is a discrete representation of a subsection of a continuous geometric space.

Mesh areas of a design are not generally uniform in size but are smaller and of higher concentration in those areas of a volume where there are features of interest having higher complexity, such as but not limited to flow features in an aircraft fuselage design.

A problem with conventional computational design technology arises from the fact that specification and identification of meshes in a design remains largely a human endeavor. In some circumstances, a person may need to labor over a design to identify all of the places where features having particular characteristics exist. And even in some technology that achieves some level of automation, a great deal of time and effort is required for a person to manually complete user-driven menus to characterize the features that are to be located within the structure.

Another problem with conventional computational design technology is the relatively slow speed of execution. The inventors of the subject matter described herein have determined, through investigation and inventive skill, that a contributing factor in this regard relates to the conventional way that a structural design is encoded (e.g., tessellation data, vector representations supplied as output from computer aided design programs, etc.).

In view of the foregoing, there is a need for technology that addresses the above and/or related problems

The following documents represent relevant prior art:
ZHAO HENGWANG ET AL: "CentroidReg: A Global-to-Local Framework for Partial Point Cloud Registration",IEEE ROBOTICS AND AUTOMATION LETTERS, IEEE, vol. 6, no. 2, 23 February 2021 (2021-02-23), pages 2533-2540, DOI: 10.1109
BEN ADALLAH HAMDI ET AL: "3D point cloud analysis for automatic inspection of aeronautical mechanical assemblies",SPIE PROCEEDINGS; [PROCEEDINGS OF SPIE ISSN 0277-786X], SPIE, US, vol. 11172, 16 July 2019 (2019-07-16), pages 111720U-111720U, DOI: 10.1117/12.2521715ISBN: 978-1-5106-3673-6
US 2021/027532 A1

### SUMMARY

It should be emphasized that the terms "comprises" and "comprising", when used in this specification, are taken to specify the presence of stated features, integers, steps or components; but the use of these terms does not preclude the presence or addition of one or more other features, integers, steps, components or groups thereof.

Moreover, reference letters may be provided in some instances (e.g., in the claims and summary) to facilitate identification of various steps and/or elements. However, the use of reference letters is not intended to impute or suggest that the so-referenced steps and/or elements are to be performed or operated in any particular order.

In accordance with one aspect of the present invention, the foregoing and other objects are achieved in technology (e.g., methods, apparatuses, nontransitory computer readable storage media, program means) that identifies a structural feature of a structure. In an aspect of some but not necessarily all embodiments consistent with the invention, identifying the structural feature involves obtaining a global point cloud representation of the structure and obtaining a target point cloud that represents a target structural feature, wherein the target point cloud is a subset of the global point cloud representation of the structure. The global structural information and the target point cloud are supplied to a global registration process that produces a globally registered representation of the structure, wherein the global structural information is derived from the global point cloud representation of the structure. The globally registered representation of the structure and the target point cloud are supplied to a local registration process that produces one or more matching point clouds, wherein each of the one or more matching point clouds is a subset of the global point cloud representation of the structure.

In another aspect of some but not necessarily all embodiments consistent with the invention, the global structural information is the global point cloud representation of the structure.

In yet another aspect of some but not necessarily all embodiments consistent with the invention, identifying the structural feature involves producing a set of one or more extracted structural features based on the global point cloud representation of the structure, wherein each of the one or more extracted structural features is a pose invariant characterization of a local geometry around a point in the global point cloud representation of the structure, and wherein the global structural information is the set of one or more extracted structural features. In another aspect of some but not necessarily all such embodiments, producing the set of one or more extracted structural features based on the global point cloud representation of the structure comprises determining a Point Feature Histogram (PFH) based on the global point cloud representation of the structure. In one possible alternative, producing the set of one or more extracted structural features based on the global point cloud representation of the structure comprises determining a Fast Point Feature Histogram (FPFH) based on the global point cloud representation of the structure.

In another aspect of some but not necessarily all embodiments consistent with the invention, identifying the structural feature involves downsampling the global point cloud representation of the structure to produce a downsampled global point cloud representation of the structure, wherein producing the set of one or more extracted structural features based on the global point cloud representation of the structure comprises producing the set of one or more extracted structural features from the downsampled global point cloud representation of the structure.

In yet another aspect of some but not necessarily all embodiments consistent with the invention, producing the one or more matching point clouds comprises identifying a subset of a locally registered representation of the structure as one of the one or more matching point clouds when a comparison between the subset of the locally registered representation of the structure and the target structural feature produces a predefined comparison result.

In yet another aspect of some but not necessarily all embodiments consistent with the invention, the predefined comparison result is a predefined root mean square error between the subset of the locally registered representation of the structure and the target structural feature.

In still another aspect of some but not necessarily all embodiments consistent with the invention, the global registration process is a RANdom SAmple Consensus (RANSAC) process.

In another aspect of some but not necessarily all embodiments consistent with the invention, the local registration process comprises determining an Iterative Closest Point (ICP) value.

In yet another aspect of some but not necessarily all embodiments consistent with the invention, obtaining the global point cloud representation of the structure comprises one or more of:
obtaining point cloud data by converting a CAD geometric representation of the structure;
obtaining point cloud data by converting a shape discretization representation of the structure;
obtaining point cloud data by converting a surface mesh representation of the structure;
obtaining point cloud data by converting a volume mesh representation of the structure; and
obtaining point cloud data by converting sensor data collected during a flight test of the structure;
obtaining point cloud data by converting sensor data collected during a physical test of the structure.

In still another aspect of some but not necessarily all embodiments consistent with the invention, identifying the structural feature involves obtaining a rule that describes a volume associated with the target structural feature, and obtaining contextual information about a locale of the target structural feature. For each of the one or more matching point clouds, a corresponding volume is produced, wherein the corresponding volume has a mesh spacing, a size, and a pose, and wherein further the mesh spacing is produced in accordance with the rule; and the size and pose are each produced based on the contextual information about the locale of the target structural feature and on contextual information about the locale of said each of the one or more matching point clouds.

In another aspect of some but not necessarily all embodiments consistent with the invention, identifying the structural feature involves obtaining one or more additional target point clouds that represent the target structural feature, wherein the one or more additional target point clouds are differently sized from one another and from the target point cloud. For each of the one or more additional target point clouds, the global structural information and said each of the one or more additional target point clouds are supplied to the global registration process that produces therefrom one or more additional globally registered representations of the structure. For each of the one or more additional target point clouds, the globally registered representation of the structure and said each of the one or more additional target point clouds are supplied to the local registration process that produces therefrom one or more additional sets of one or more matching point clouds.

In another aspect of some but not necessarily all embodiments consistent with the invention, a computer program product is configured for carrying out any one or more of the aspects herein described.

In yet another aspect of some but not necessarily all embodiments consistent with the invention, a nontransitory computer readable storage medium comprises program instructions that, when executed by one or more processors, carries out any one or more of the aspects herein described.

In another aspect of some but not necessarily all embodiments consistent with the invention, a system comprising one or more processors configured to carry out any one or more of the aspects herein described.

In yet another aspect of some but not necessarily all embodiments consistent with the invention, a structural feature recognizer for use in computational engineering is provided, wherein the structural feature recognizer is configured to carry out any one or more of the aspects herein described.

In still another aspect of some but not necessarily all embodiments consistent with the invention, computational engineering system is provided that comprises a structural feature recognizer for use in computational engineering, wherein the structural feature recognizer is configured to carry out any one or more of the aspects herein described.

### BRIEF DESCRIPTION OF THE DRAWINGS

The objects and advantages of the invention will be understood by reading the following detailed description in conjunction with the drawings in which:
Figure 1 is, in one respect, a flowchart of actions of a structural feature identifier consistent with the invention.
Figure 2 is a flowchart of actions associated with a step/element that obtains a point cloud representation of a structure.
Figure 3 is, in one respect, a flowchart of some actions of a structural feature recognizer in accordance with some embodiments consistent with the invention.
Figure 4 is, in one respect, a flowchart of some actions of a structural feature recognizer in accordance with some embodiments consistent with the invention.
Figure 5 is a point cloud representation of an exemplary aircraft.
Figure 6 shows a computer-generated image of the nose section of the aircraft of Figure 5.
Figures 7A, 7B, 7C, 7D, and 7E illustrate aspects of feature identification and mesh generation in accordance with inventive embodiments.
Figure 8 illustrates the extent of a volume that is subject to the new rule in accordance with aspects of some inventive embodiments.
Figure 9 illustrates a target structural feature and nine other vortex generators automatically identified by an exemplary embodiment of the invention.
Figure 10 illustrates how an original rule is automatically copied to produce copied volumes at other matching locations.
Figure 11 shows an exemplary structural feature recognizer that is configured to cause any and/or all of the herein-described and illustrated actions to be performed.

### DETAILED DESCRIPTION

The various features of the invention will now be described with reference to the figures, in which like parts are identified with the same reference characters.

The various aspects of the invention will now be described in greater detail in connection with a number of exemplary embodiments. To facilitate an understanding of the invention, many aspects of the invention are described in terms of sequences of actions to be performed by elements of a computer system or other hardware capable of executing programmed instructions. It will be recognized that in each of the embodiments, the various actions could be performed by specialized circuits (e.g., analog and/or discrete logic gates interconnected to perform a specialized function), by one or more processors programmed with a suitable set of instructions, or by a combination of both. The term "circuitry configured to" perform one or more described actions is used herein to refer to any such embodiment (i.e., one or more specialized circuits alone, one or more programmed processors, or any combination of these). Moreover, the invention can additionally be considered to be embodied entirely within any form of nontransitory computer readable carrier, such as solid-state memory, magnetic disk, or optical disk containing an appropriate set of computer instructions that would cause a processor to carry out the techniques described herein. Thus, the various aspects of the invention may be embodied in many different forms, and all such forms are contemplated to be within the scope of the invention, which is defined by the appended claims. For each of the various aspects of the invention, any such form of embodiments as described above may be referred to herein as "logic configured to" perform a described action, or alternatively as "logic that" performs a described action.

One aspect of inventive embodiments is the use of a point cloud representation of a structural design. Unlike the conventional use of, for example, named elements and geometric types, the use of point clouds is more flexible and facilitates the adaptation of recent advances in machine vision technology for a new purpose, namely, solving feature recognition in a structural design.

Another aspect of inventive embodiments is feature recognition/identification by means of recognition of geometric similarity and registration. Unlike conventional technology, the embodiments consistent with the invention can detect similarity that is not constrained by dimension or type, because the underlying data structure is simply an arbitrary set of points in 3D space (i.e., a point cloud).

Yet another aspect of some but not necessarily all inventive embodiments is the modification of mesh generation rules based on locale-related contextual information and the application of the modified rules to automatically identified structural features.

These and other aspects are now described in further detail in the following discussion.

Registration algorithms are known in the art and are widely used in image processing applications. The goal of registration is typically to transform a collection of separate data sets so that they are all relative to a same coordinate system. This is useful, for example, when it is desired to overlay separately obtained images (e.g., any combination of photographs, sensor data, computer generated images, etc.) to produce a single image. One of many possible exemplary uses of registration can be found in augmented reality technology, in which computer generated graphic images are overlayed on top of one or more real world images. It is registration that allows the user to experience the computer generated image as existing at the intended location of the real world.

The inventors have recognized, through investigation and inventive skill, that registration algorithms can be used outside the context of image processing, and more particularly for the purpose of locating structural features that match a target feature of interest within a global structure. However, the fast global registration of sub-scale features within a much larger shape is a difficult problem, especially when point cloud representations are used. Machine vision for automation tend to assume a similar number of points and scales in the source and target point clouds and registration is preceded by a segmentation step (splitting the target into multiple separate parts, one of which will match the source - for example a moving car in a machine vision system based on LIDAR).

The inventors of the subject matter described herein have recognized that the functionality of registration can be applied to automatically locate features in a structure. However, unlike applications such as machine vision, feature matching presents the unique challenge of matching part of a contiguous target set to a source set of points where there may be no straightforward way to segment the data set a-priori.

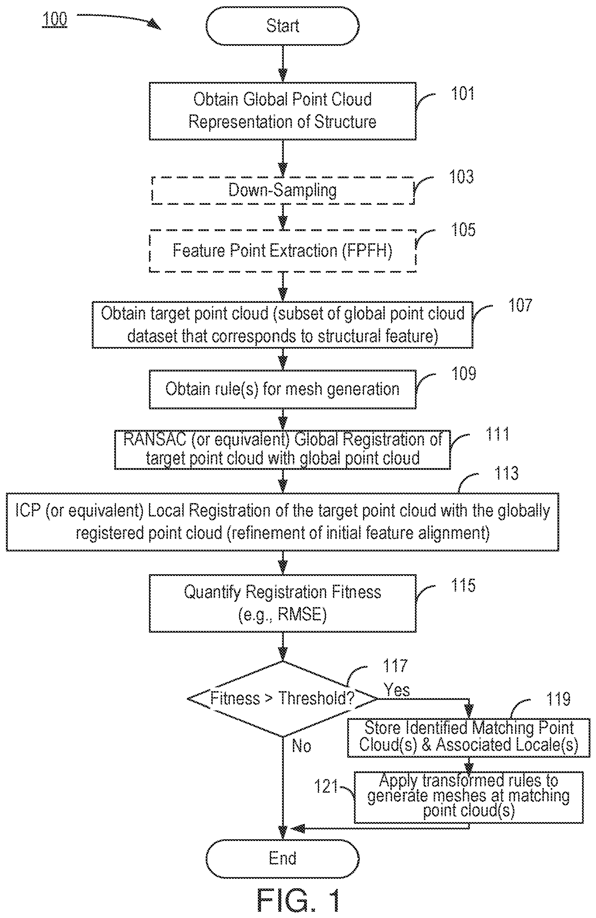

The above mentioned challenges are resolved in the various inventive embodiments, such as that shown in Figure 1 which, in one respect, is a flowchart of actions of a structural feature identifier consistent with the invention. In other respects, the blocks depicted in Figure 1 can also be considered to represent means 100 (e.g., hardwired or programmable circuitry or other processing means) for carrying out the described actions.

In an aspect of embodiments consistent with the invention, the process of recognizing features in an engineering model or structure and applying relevant rules to the onward computational process is uniquely based on points rather than any higher-order definition (such as CAD or imagery). This is because point clouds are a generic data representation that allows information about volumes (rather than surfaces) and measured (rather than computational) data values to be input to a single process without the need for specific data / file formats and without the need for representation types that are not suited to the data being represented - for example surface tufting on a 737 flight test. Therefore, one step is obtaining a point cloud representation of the structure (step 101).

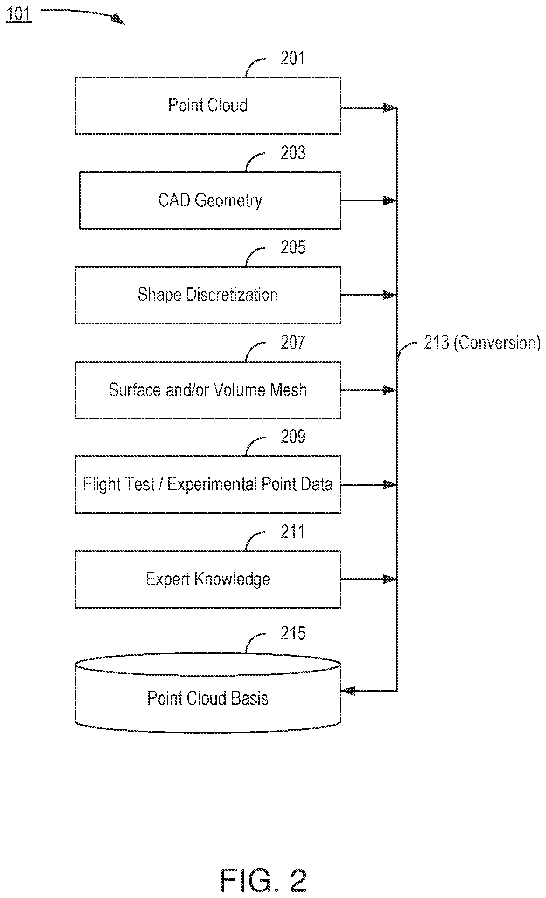

Some, but not necessarily all, embodiments may further include the in-situ conversion of any other data representation to point clouds before global registration against the additional rule library is performed. This is unlike the geometry-based approaches, where rules are associated with named and tagged geometry (surfaces) before any discretization. This makes the current process ideally suited to the processing of computational engineering data sources based on product shape, regardless of representation. Accordingly, the step of obtaining the point cloud representation of the structure may need to include additional conversion steps. This is illustrated in Figure 2, which, in one respect, is a flowchart of actions associated with step/element 101.

As shown in Figure 2, the workspace can include data sources from any one or more of:
i. Point Clouds 201,
ii. CAD Geometry 203,
iii. Shape Discretization 205,
iv. Computational Surface and/or Volume Meshing 207,
v. Flight Test Sensor Data and Data obtained through Physical Experiment 209,
vi. Sensor data collected during a physical test of the structure (e.g., full scale or model),
vii. Expert Knowledge 211 encoded in tables, text or imagery or input via a software GUI.

Valuable information relevant to computational engineering can be obtained from physical experiments using real-world structures relating to computationally designed structures. In such cases, the data from physical experiments may be from any one or more of: electronic sensors, direct measurements that are transcribed, photography with interpretation, and other forms of data capture. Examples of electronic sensors include, but are not limited to, electro-optic, pressure gauge, thermal, infra-red, accelerometer, acoustic (microphone), and strain gauge sensors.

In each case, data points with values of interest are generated. Conversion to point cloud format is straightforward as the data points and values require no additional structure.

Except for the case in which data originates as a point cloud 201, the remaining formats are first converted into point cloud representation (step 213) before all data is collected as a single point cloud dataset 215.

Referring back to Figure 1, an optional next step is down-sampling the point cloud dataset 215. This reduces the amount of data that needs to be processed, which in turn speeds up processing. To ease the description, as used herein, references to the "point cloud dataset" refer to the original dataset of step 101 if optional down-sampling 103 has been omitted in a given embodiment, and instead refer to the down-sampled point cloud dataset when optional down-sampling 103 has been performed.

An optional next step is feature point extraction (step 105), in which the point cloud dataset is processed to produce data representing one or more extracted features that characterize the local geometry around one or more points in the point cloud dataset, where the extracted features are preferably pose invariant with good discriminative power. Algorithms for performing suitable feature point extraction, such as Point Feature Histogram (PFH) and Fast Point Feature Histogram (FPFH) are known in the art, as exemplified by Rusu et al., "Fast Point Feature Histograms (FPFH) for 3D Registration", 2009 IEEE International Conference on Robotics and Automation, 2009, pp. 3212-3217, doi: 10.1109/ROBOT.2009.5152473. Accordingly, a thorough description of such algorithms is beyond the scope of this disclosure.

Next, in step 107, a target point cloud is obtained. The target point cloud is a subset of the global point cloud representation and represents a structural feature of interest (e.g., to a designer of the structure). The target point cloud may be supplied by a user of the inventive technology, or by an Artificial Intelligence (AI) that has been trained to automatically identify types of features that are of interest.

As one goal of the design process is to generate suitable meshes for each structural feature of interest, wherein the meshes are not represented in the original global point cloud (e.g., in the examples presented herein, meshes that define vortexes generated by vortex generators), another step is obtaining a rule that describes the mesh that is to be generated for the target point cloud (step 109), taking into account contextual information related to the locale of the target point cloud. It is noted that a mesh for a target point cloud may be at the location of the target point cloud but is not required to be. To take one, non-limiting example, if the target point cloud represents a vortex generator, the required area of mesh refinement will be downstream of the vortex generator itself. As with the data representing the structure, rules may be initially represented in any data source.

Rules for computational engineering processes can be linked to specific features in the point cloud representation of products and associated data sources, but the rules themselves need not be in point cloud representation. An example is mesh generation for aerodynamics where certain aircraft body parts require special treatment - normally input by an expert or via feedback from a downstream process. After matching point clouds corresponding to additional instances of target structural features of interest are identified at different locations on the aircraft body (or more generally, to whatever type of structure is being designed), the computational engineering rules are applied at the feature locations, with a transformation in space according to the registration transformation, in order to generate appropriate meshes associated with the identified features.

As mentioned earlier, registration is a process in which separate datasets, having different coordinate systems, can be aligned to a common coordinate system, such as in image processing applications. The inventors have recognized that the finding of a point of alignment can also be useful in a computational engineering environment for indicating when a subset of points in a point cloud match those of a known feature, and for that reason, next steps include performance of a global registration that seeks to find a match between each target point cloud and the extracted features (or more generally, of the global point cloud in embodiments that do not incorporate feature extraction).

To perform this quickly, it is advantageous to first perform a global registration of the target point cloud with the global point cloud (step 111), and then to refine the initial feature alignment by performing a local registration of the target point cloud with the globally registered point cloud (using a different algorithm) (step 113). The output of the local registration is a set of one or more matching point clouds, corresponding to features of interest on the structure that match the target point cloud. Accordingly, in the exemplary embodiment, the first registration procedure can be, for example, a RANdom SAmple Consensus (RANSAC) process or similar. Global registration processes are known generally, outside the context of the herein-described inventive embodiments (e.g., for alignment of images of 3-dimensional (3D) shapes for the purpose of creating a single 3D image from separate images). See, for example, Zhou et al., "Fast Global Registration", 9906. 10.1007/978-3-319-46475-6_47 (2016).

The local registration process can be, for example, an Iterative Closest Point (ICP) process or similar. The use of ICP for use outside the context of the herein-described inventive embodiments (e.g., for alignment of images of 3D shapes for the purpose of creating a single 3D image from separate images) is generally known in the art. See, for example, Gelfand et al., "Robust Global Registration", SGP05: Eurographics Symposium on Geometry Processing, The Eurographics Association pp. 197-206 (2005).

A benefit of the strategy in which global registration and local registration are performed in sequence is that the global registration of the target point cloud with the global point cloud conditions the point cloud data such that points are clustered around potential features of interest in the structure. This clustering has the effect of creating a subset of points for the local registration to consider, thereby enabling the local registration process to work satisfactorily. Otherwise, local registration by itself would be ineffective.

To ensure accuracy in the exemplary embodiment, a measure of registration fitness is produced for each of the matching point clouds identified by the registration processes. This can be done by, for example, producing a fitness estimate representing a distance between the target point cloud and each automatically identified matching point cloud (step 115). The measure of fitness can be, for example, a Root Mean Square Error (RMSE) value.

The measure of fitness of the matching point cloud is compared with a threshold value (representing a minimum acceptable level of fitness), and if the fitness of an identified matching point cloud satisfies the comparison ("Yes" path out of decision block 117), the identified matching point cloud and contextual information describing its associated locale are stored or otherwise made available to a designer (step 119).

Having identified matching point clouds of the target point cloud within the global point cloud, corresponding meshes for those matching point clouds are generated. Doing so requires that the rules for mesh generation take into consideration the context of those matching point clouds in relation to the context of the locale in which the target point cloud is situated (e.g., the pose and surrounding elements of each given point cloud), since the newly generated mesh should fit within the context of the matching point cloud's locale. Rules for generating computational engineering meshes at the locations of the identified matching point clouds are created by adapting/transforming the rules associated with the target point cloud (step 121) based on the relation between the locale of the target point cloud and that of the matching point cloud. The transformed rules are then applied to generate respective meshes for each matching point cloud (step 121).

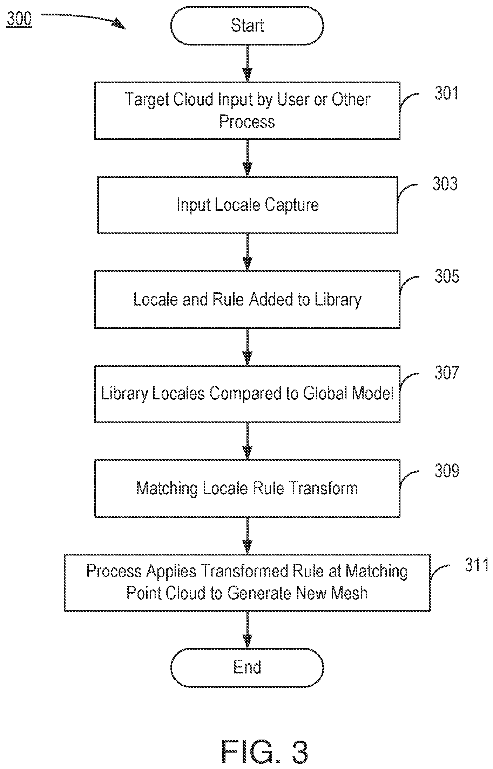

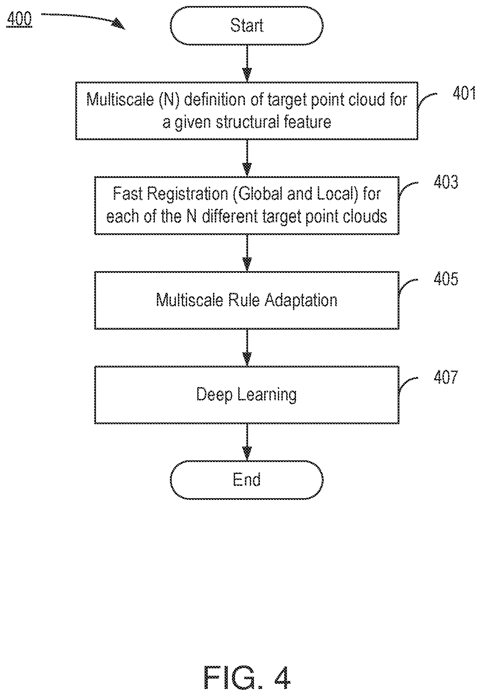

An exemplary embodiment involving the locale-dependent rule transformation of step 121 is illustrated in Figure 3 which, in one respect, is a flowchart of actions of a structural feature identifier consistent with the invention. In other respects, the blocks depicted in Figure 3 can also be considered to represent means 300 (e.g., hardwired or programmable circuitry or other processing means) for carrying out the described actions. Actions involved in this aspect include:
- Input of a target point cloud by a user or a downstream process (step 301).
- Input of locale capture (step 303), which serves as the reference context against which the contexts (locales) of matching point clouds are compared.
- Adding the locale and rule to a library (step 305).
- Comparing library locales to a global model (step 307). This is described further in connection with Figure 4.
- Transforming rules of matching locales based on the comparison of library locales to the locales of the matching point clouds (step 309).
- Applying transformed rules to generate meshes at identified matching point clouds (step 311).

Referring back to decision block 117 in Figure 1, if the fitness of an identified matching point cloud does not satisfy the comparison with the threshold level of fitness ("No" path out of decision block 117), the identified matching point cloud is not considered further.

Further aspects of some but not necessarily all inventive embodiments involve multiscale registration, which is advantageous in use cases in which the details of the mesh generation rules to be applied for an identified feature are not the same at different locales. For example, the same vortex generator shape may require a longer downstream volume of mesh refinement when located on the leading edge of a wing than when located near the windscreen of an aircraft. Considering this aspect in further detail, it will be appreciated that the use of deep learning algorithms for multi scale registration (matching point clouds and locales) requires the automatic generation of recognizable patterns of points at multiple length scales determined from the global model. For example, if one looks at the surface of a sphere at very small distance from the surface, the shape appears to be flat; if the entire sphere is viewed, then one sees a set of points equidistant from a central point; and if one moves very far away, then one sees just a single point. For an aircraft, if one considers a vortex generator near the nose of the aircraft one sees a vortex generator on a flat surface; or a vortex generator on a cylinder; or a vortex generator just in front of a flat surface (the window of the aircraft); or a vortex generator near the front of a long cylindrical body, all depending on the distance of the observation point relative to the structure (or equivalently, depending on the size of the point cloud under consideration). For the same vortex generator at the rear of the aircraft near the tail, one sees a vortex generator on a flat surface; or a vortex generator on a cylinder; or a vortex generator near a large vertical lifting surface (the tail) and a large horizontal lifting surface (the horizontal stabilizer); or critically a vortex generator near the rear of a large cylinder - where the fluid dynamic boundary layer is considerably thicker than at the front of the aircraft. Again, what one sees is dependent on the size of the point cloud under consideration.

In view of the above, in another aspect of some but not necessarily all inventive embodiments, it is often advantageous in the computational engineering design process to automatically represent the global point cloud at (N) multiple useful length scales, with associated library entries as multiscale segmentation, where each scale acts as a modifier to the base rule library. To illustrate this aspect, reference is made to Figure 4 which, in one respect, is a flowchart of actions of a computational engineering design tool consistent with the invention. In other respects, the blocks depicted in Figure 4 can also be considered to represent means 400 (e.g., hardwired or programmable circuitry or other processing means) for carrying out the described actions. Actions involved in this aspect include:
- Multiscale definitions of the target point cloud for a given structure feature (produces N differently sized/scaled target point clouds for a given structural feature) (step 401). The choice of the different scales can by input by a user or can be automatically generated via deep learning technology.
- Perform fast registration (e.g., global registration followed by local registration as illustrated by steps 111 and 113 of Figure 1) for each of the N different target point clouds (step 403). Some matching point clouds may be identified in more than one of the N executions of fast registration, and others may be present in only one, all depending on what the feature is and how similar or dissimilar the related feature locales are from one another at different scales.
- Multiscale rule adaptation (step 405) to produce rules that are appropriate for each respective one of the N differently sized point clouds.
- Deep learning (step 407).

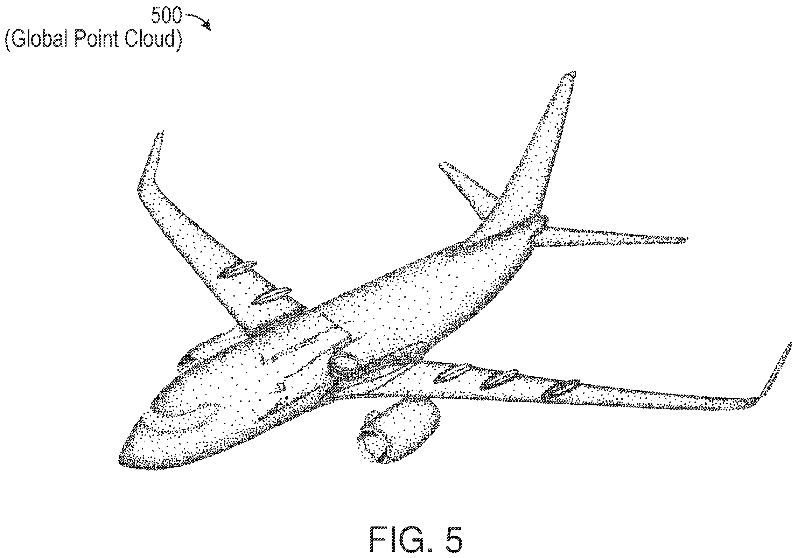

Further aspects of embodiments consistent with the invention are now described in the context of a non-limiting example. Figure 5 is a global point cloud representation of an aircraft 500 (in this case, a Boeing 737). In this example, it is desired to identify the ten independent counter-rotating vortex generator pairs at the front of the aircraft 500, given just one of these pairs. The vortex generator pair therefore serves as the structural feature discussed above.

To identify vortex generators in this design, an initial step is obtaining a good quality digital geometry definition (such as CAD) that represents the shape of the object to be studied to sufficient accuracy. In this case, the geometry is a CAD representation of the aircraft 500.

**In** order to represent the shape as a point cloud, a basic mesh is produced by sampling the geometry with an octree (or other suitable discretization), which produces a large number of points. For this particular aircraft, the global point cloud 500 contains approximately 1 million surface points.

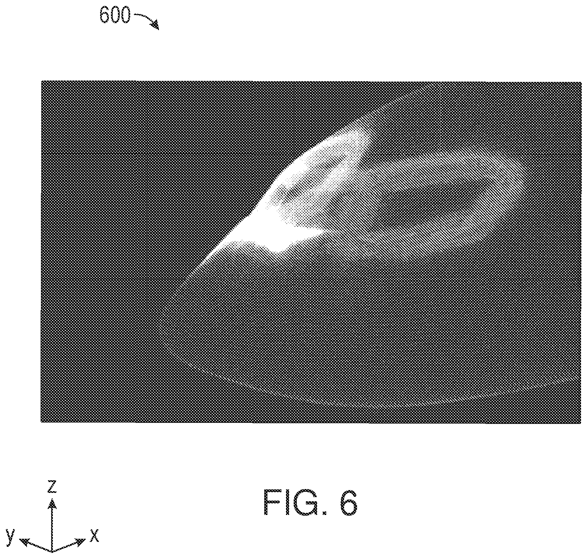

Figure 6 shows a computer-generated image of the nose section 600 of the aircraft's global point cloud 500. It can be seen that the point cloud is already clustered around areas with small features or high curvature.

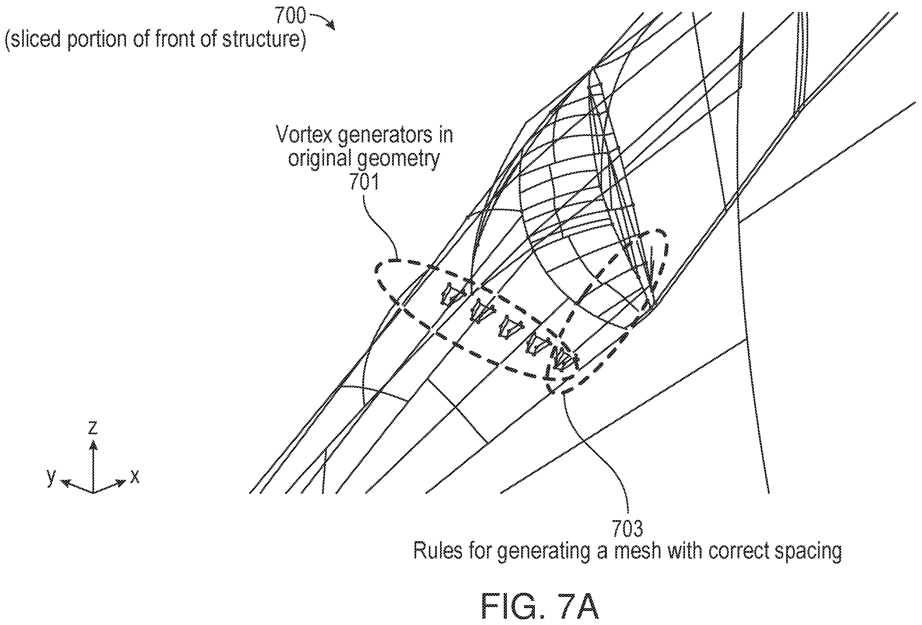

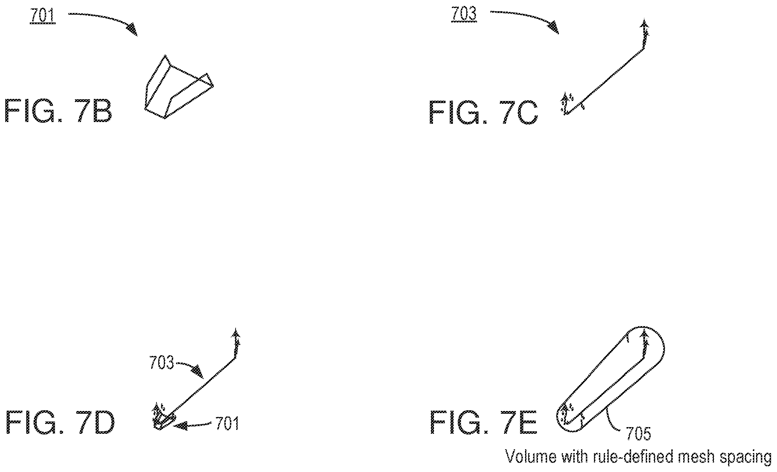

Figures 7A, 7B, 7C, 7D, and 7E illustrate aspects of feature identification and mesh generation. Referring first to Figure 7A (to simplify the figure, the fuselage has been sliced down a center line extending from front to back of the aircraft and only one slice is shown in the figure), the basic rules (feature size, surface curvature) do not completely define the required mesh spacing. To address this problem, one of the vortex generators 701 (the target structural feature) is identified in the original geometry (e.g., by an expert user). The expert user then adds in a set of rules 703 for generating a mesh with the correct spacing given the locale of the target feature. An expert will use a "sourcing rule" to add in more information before the final mesh is produced.

Figure 7A illustrates the vortex generators 701 and the rules 703 for generating the mesh in context (i.e., as they are positioned in the nose section 600 of the aircraft's global point cloud 500). For the sake of clarity, Figure 7B is an enlarged, isolated illustration of one of the vortex generators 701; Figure 7C is an isolated illustration of the rules 703 for generating the mesh; Figure 7D is an isolated illustration of the rules 703 for generating the mesh, in its placement relative to one of the vortex generators 701; and Figure 7E illustrates a mesh 705 generated from the rule when applied in context at the location of the target vortex generator.

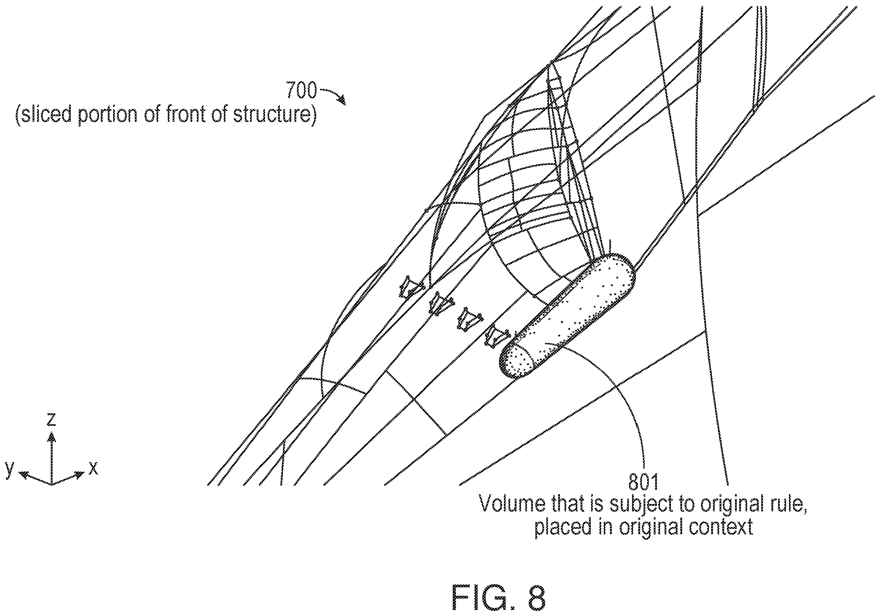

Figure 8 illustrates the extent of a volume 801 that is subject to the new rule when placed in context on the structure.

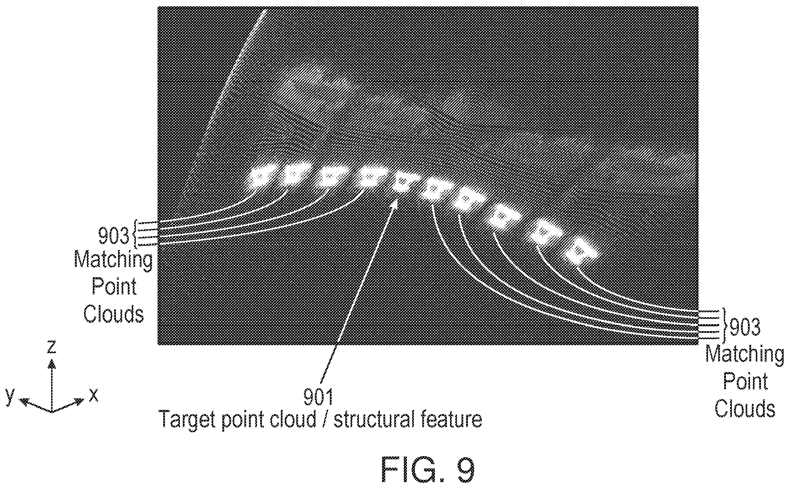

Referring now to Figure 9, in an aspect of inventive embodiments, the technology eliminates the need for an expert to repeat the process of rule specification for each of the ten vortex generator pairs. Instead, the inventive embodiments start with a target point cloud 901 (corresponding to a target structural feature of interest) and apply fast feature recognition as described above to find the same shapes in the rest of the volume, given its point cloud representation. In particular, Figure 9 illustrates this aspect, showing a target point cloud 901 (in this example, a vortex generator represented by approximately 3000 points) and nine other automatically identified matching point clouds 903 that similarly correspond to vortex generators.

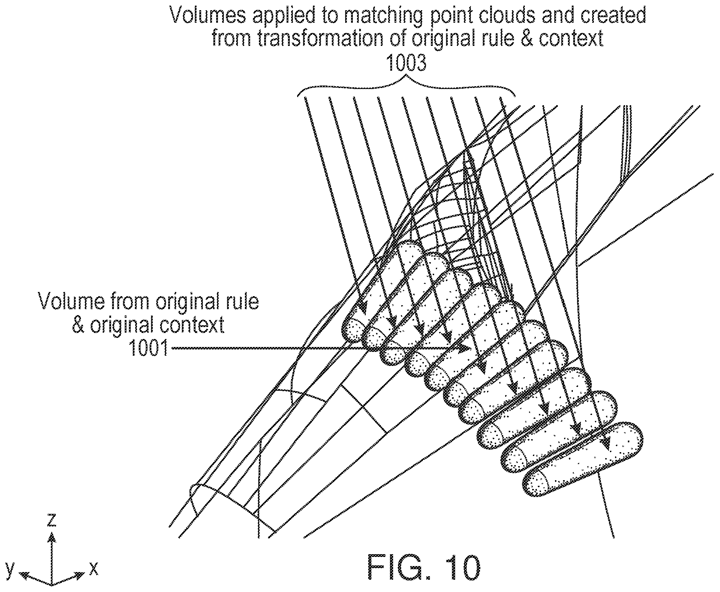

The rules exist as a set of points which are used to define the mesh spacing. Once a target set of point cloud matches is found for the original vortex generator, the mesh generation rules are transposed to the new location(s). Figure 10 illustrates this aspect, depicting an original volume 1001 generated from an original rule, and showing how the original rule is automatically transformed (e.g., scaling and reorientation) and applied to the matching point clouds 903 to produce cloned volumes 1003 at the other nine matching locations.

In other aspects of some but not necessarily all embodiments consistent with the invention, the rules specified for each structural feature (e.g., in this example, a vortex generator) are used to determine the level of mesh refinement (spacing) nearby. Where the initial rules have been specified a-priori, the downstream use of the resulting mesh may confirm or contradict the need for such a spacing. For example, the spacing may be overly cautious (refined). **In** such cases, the gradients in the resulting flow solution would have been captured by a less refined (i.e., coarser) mesh. The associated rule can then be automatically modified so as to maintain solution accuracy with a better optimized spacing.

The best rules for any given identified feature may depend upon the feature context, and in some but not necessarily all embodiments, the rules are modified based on context. Contextual information includes:
1. The purpose of the model. For example the accuracy requirements for drag are more demanding on solution accuracy than are those for lift.
2. The surrounding geometry. For example a vortex generator on the leading edge of a wing will require a different downstream mesh refinement to maintain appropriate solution accuracy when compared with the same vortex generator located near the front windscreen. This will use a larger domain surrounding the target point cloud, sampled with a larger voxel size for the feature points. Thus the geometric context of vortex generators on the leading edge will all be similar to each other, but quite different from the nose of the aircraft. Each context would require its own rule modification.

In yet another aspect of some but not necessarily all inventive embodiments, data sources external to the computational fluid dynamics (CFD) process can also be used to modify the rules. For example, measurements of the flow on a real aircraft (pressure taps, tufting, oil scar photography) can establish the need for modified spacing rules when the measured data is made available in point cloud format.

Further aspects of some but not necessarily all inventive embodiments will be appreciated from the following program code (written in the Python programming language), which shows exactly how to identify the ten independent antisympathetic vortex generator pairs at the front of the aircraft's global point cloud 500 of Figure 5, given just one of these pairs. This serves as a non-limiting example from which the person of ordinary skill in the art will gain further insight into how to make and use embodiments consistent with the invention.

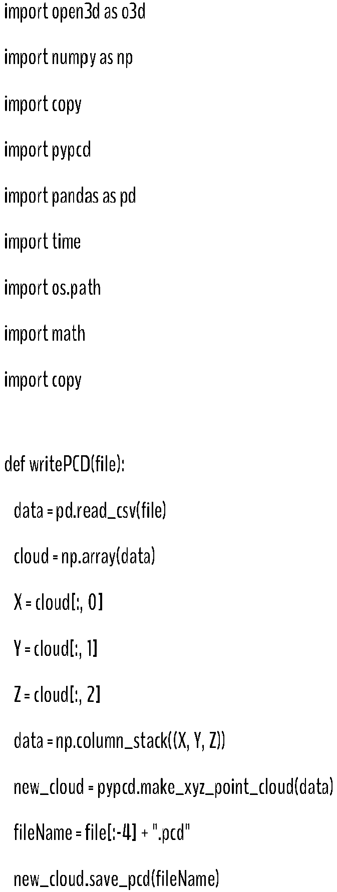

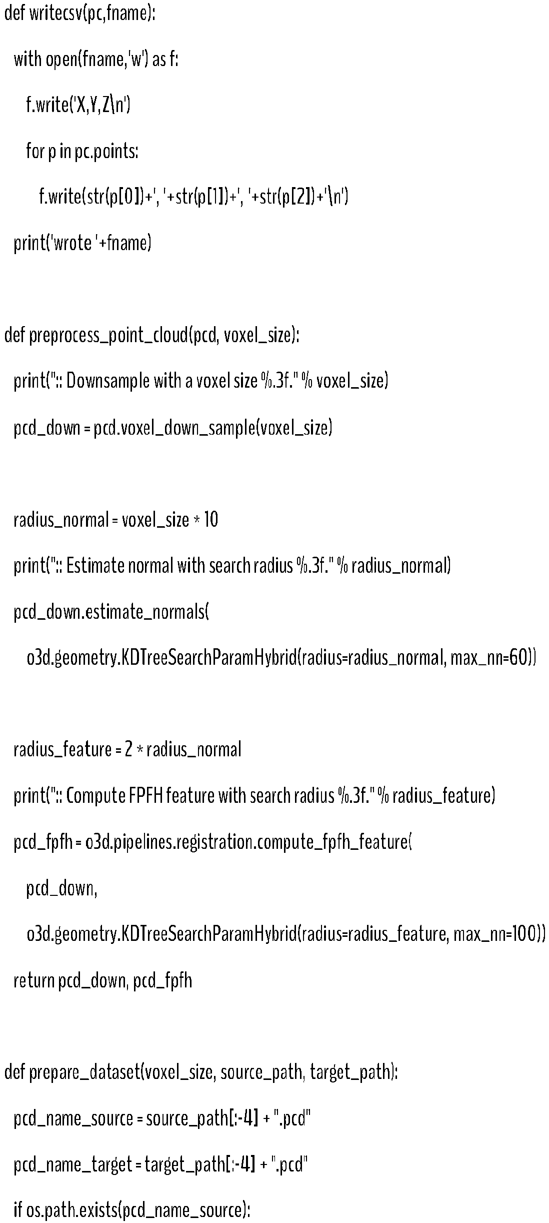

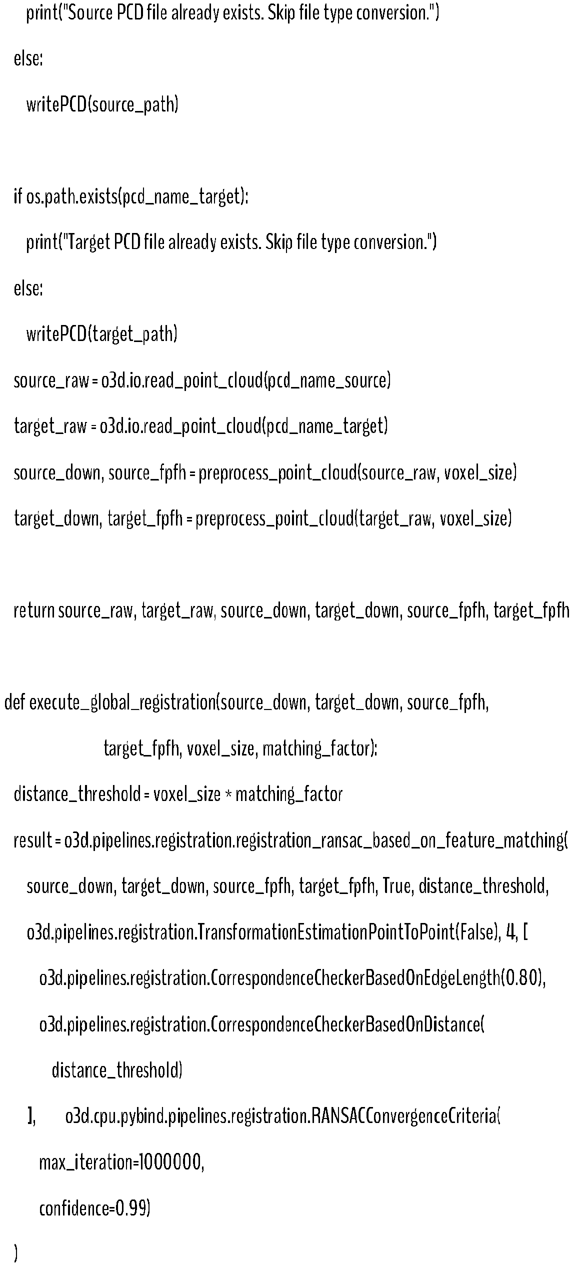

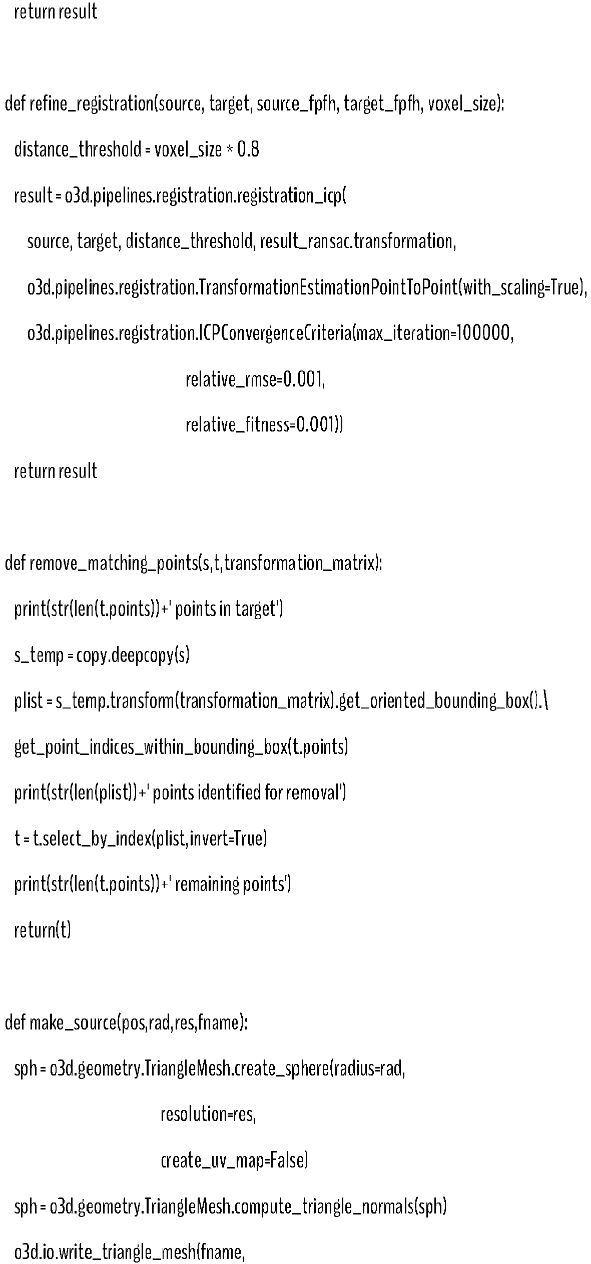

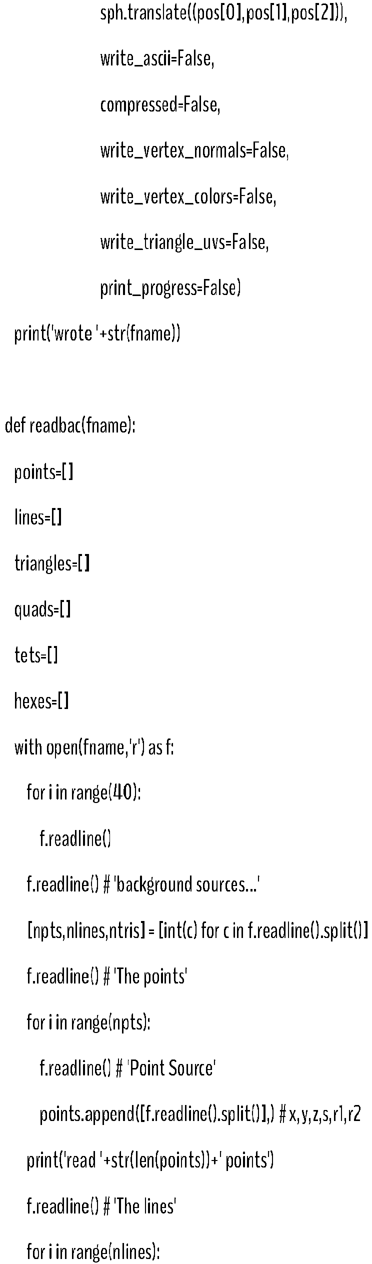

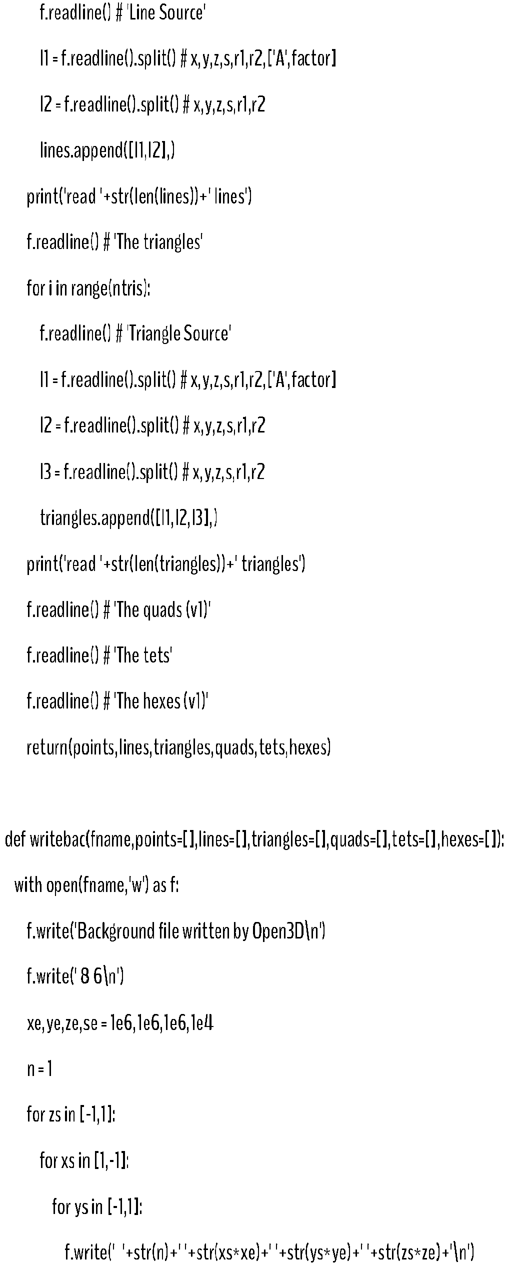

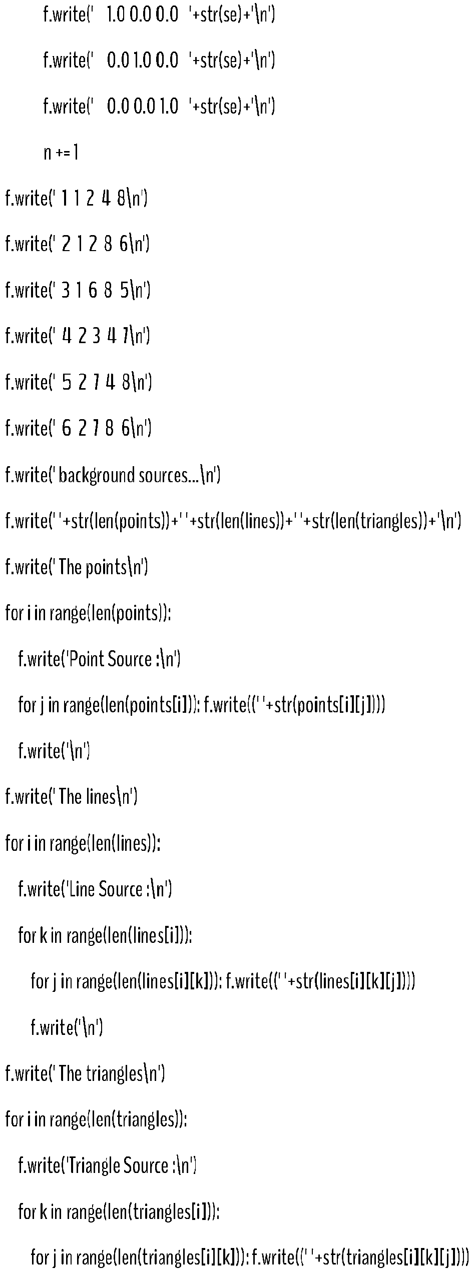

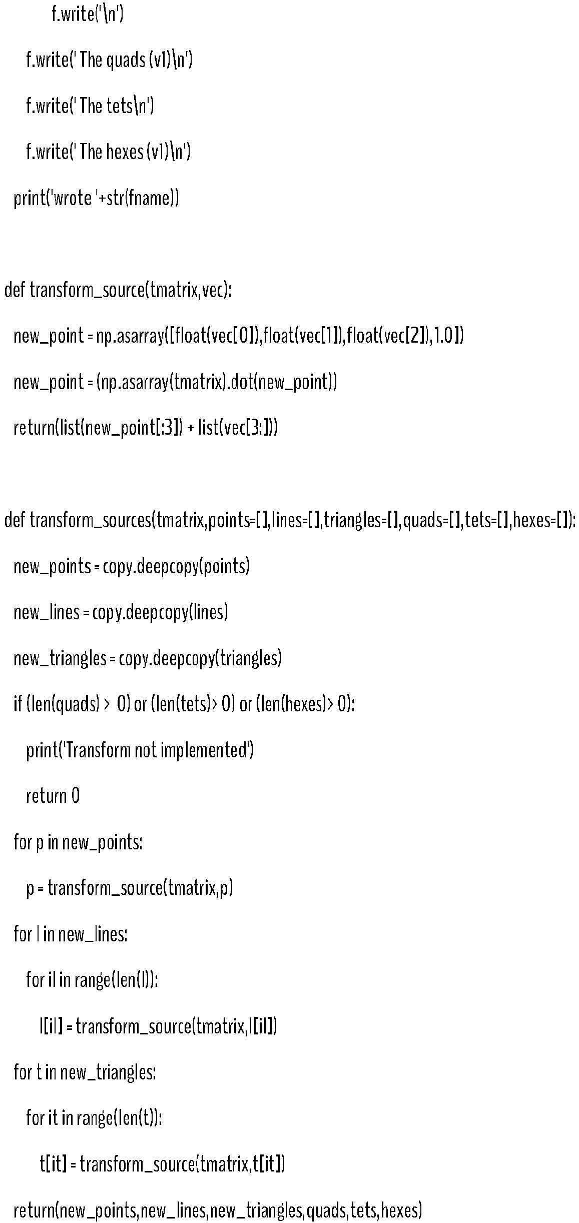

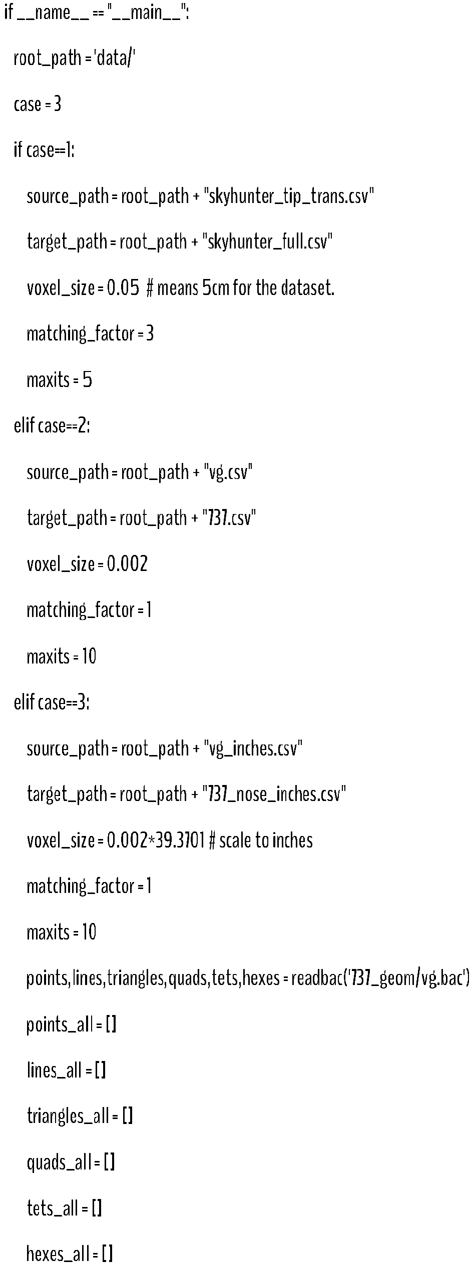

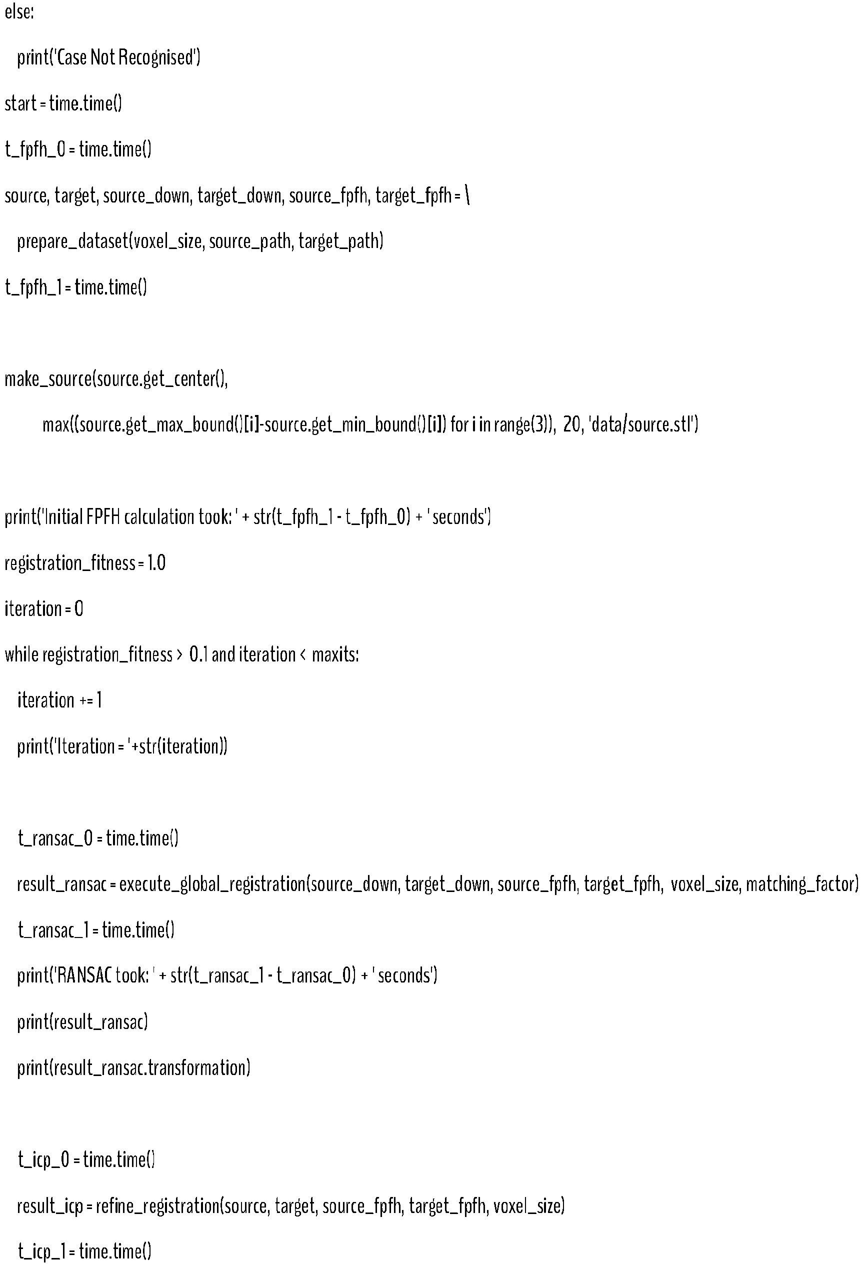

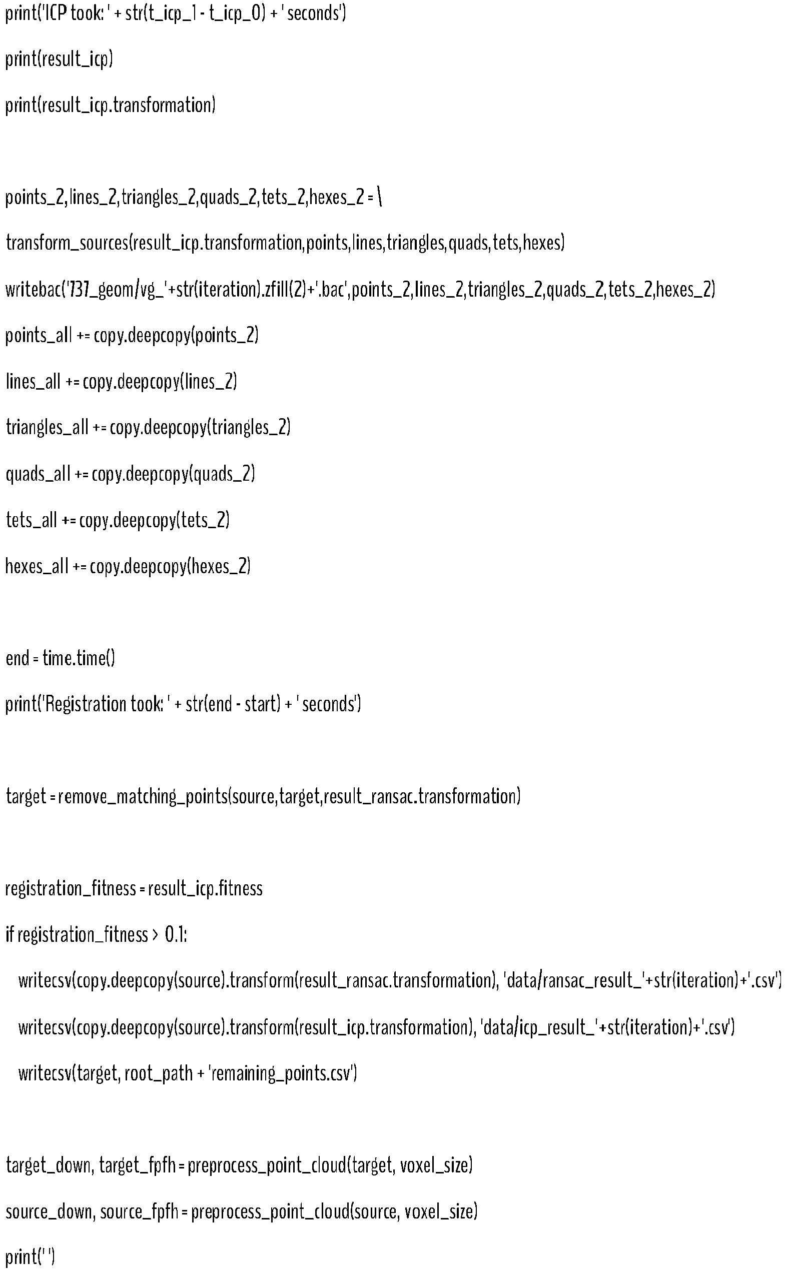

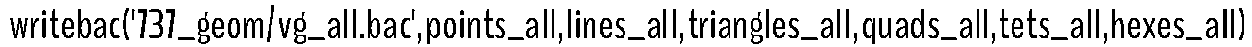

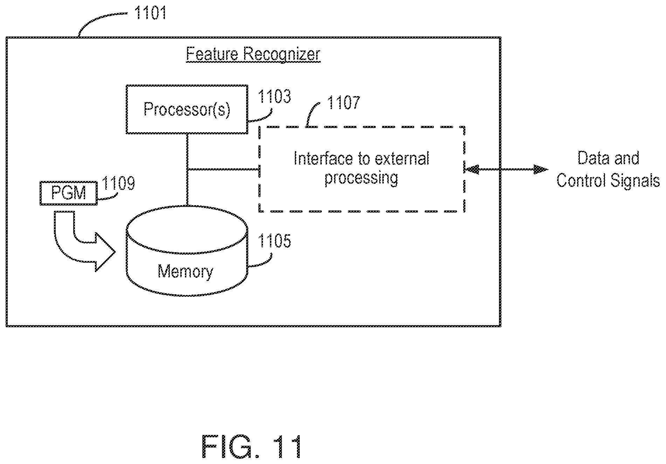

Further aspects of embodiments consistent with the invention will now be described with reference to Figure 11, which shows an exemplary structural feature recognizer and mesh generator 1101 that is configured to cause any and/or all of the herein-described and illustrated actions to be performed. In particular, the structural feature recognizer and mesh generator 1101 includes circuitry configured to carry out any one or any combination of the various functions described herein. Such circuitry could, for example, be entirely hard-wired circuitry (e.g., one or more Application Specific Integrated Circuits - "ASICs"). Depicted in the exemplary embodiment of Figure 11, however, is programmable circuitry, comprising one or more processors 1103 coupled to one or more memory devices 1105 (e.g., Random Access Memory, Magnetic Disc Drives, Optical Disk Drives, Read Only Memory, etc.) and to an interface 1107 that enables bidirectional communication of data and/or control signals with other components (e.g., Input/Output devices) and in some but not necessarily all inventive embodiments, other processing resources that may carry out some of the processing described herein. A complete list of possible other elements is beyond the scope of this description.

The memory device(s) 1105 store program means 1109 (e.g., a set of processor instructions) configured to cause the one or more processors 1103 to control other device elements so as to carry out any of the aspects described herein. The memory device(s) 1105 may also store data (not shown) representing various constant and variable parameters as may be needed by the one or more processors 1103 and/or as may be generated when carrying out its functions such as those specified by the program means 1109.

The invention has been described with reference to particular embodiments. However, it will be readily apparent to those skilled in the art that, having learned and then applying aspects of the technology from this disclosure, it is possible to embody the invention in specific forms other than those of the embodiments described above. Thus, the described embodiments are merely illustrative and should not be considered restrictive in any way. The scope of the invention is defined by the appended claims, rather than by the preceding description, and all variations and equivalents which fall within the range of the claims are intended to be embraced therein.

## Claims

1. A method of identifying a structural feature of a structure, the method comprising:
obtaining a global point cloud representation of the structure;
obtaining a target point cloud that represents a target structural feature, wherein the target point cloud is a subset of the global point cloud representation of the structure;
supplying global structural information and the target point cloud to a global registration process and producing therefrom a globally registered representation of the structure, wherein the global structural information is derived from the global point cloud representation of the structure; and
supplying the globally registered representation of the structure and the target point cloud to a local registration process and producing therefrom one or more matching point clouds, wherein each of the one or more matching point clouds is a subset of the global point cloud representation of the structure.

2. The method of claim 1, wherein the global structural information is the global point cloud representation of the structure.

3. The method of claim 1, comprising:
producing a set of one or more extracted structural features based on the global point cloud representation of the structure, wherein each of the one or more extracted structural features is a pose invariant characterization of a local geometry around a point in the global point cloud representation of the structure,
wherein the global structural information is the set of one or more extracted structural features.

4. The method of claim 3, wherein producing the set of one or more extracted structural features based on the global point cloud representation of the structure comprises:
determining a Point Feature Histogram (PFH) based on the global point cloud representation of the structure.

5. The method of claim 3, wherein producing the set of one or more extracted structural features based on the global point cloud representation of the structure comprises:
determining a Fast Point Feature Histogram (FPFH) based on the global point cloud representation of the structure.

6. The method of claim 3, comprising:
downsampling the global point cloud representation of the structure to produce a downsampled global point cloud representation of the structure,
wherein producing the set of one or more extracted structural features based on the global point cloud representation of the structure comprises:
producing the set of one or more extracted structural features from the downsampled global point cloud representation of the structure.

7. The method of any one of the previous claims, wherein producing the one or more matching point clouds comprises:
identifying a subset of a locally registered representation of the structure as one of the one or more matching point clouds when a comparison between the subset of the locally registered representation of the structure and the target structural feature produces a predefined comparison result.

8. The method of claim 7, wherein the predefined comparison result is a predefined root mean square error between the subset of the locally registered representation of the structure and the target structural feature.

9. The method of any one of the previous claims, wherein the global registration process is a RANdom SAmple Consensus (RANSAC) process.

10. The method of any one of the previous claims, wherein the local registration process comprises determining an Iterative Closest Point (ICP) value.

11. The method of any one of the previous claims, wherein obtaining the global point cloud representation of the structure comprises one or more of:
obtaining point cloud data by converting a CAD geometric representation of the structure;
obtaining point cloud data by converting a shape discretization representation of the structure;
obtaining point cloud data by converting a surface mesh representation of the structure;
obtaining point cloud data by converting a volume mesh representation of the structure;
obtaining point cloud data by converting sensor data collected during a flight test of the structure; and
obtaining point cloud data by converting sensor data collected during a physical test of the structure.

12. The method of any one of claims 1-10, wherein obtaining the global point cloud representation of the structure comprises:
obtaining the point cloud data by converting a global non-point cloud representation of the structure into the global point cloud representation of the structure.

13. The method of any one of the previous claims, comprising:
obtaining a rule that describes a volume associated with the target structural feature;
obtaining contextual information about a locale of the target structural feature; and
producing, for each of the one or more matching point clouds, a corresponding volume having a mesh spacing, a size, and a pose,
wherein:
the mesh spacing is produced in accordance with the rule; and
the size and pose are each produced based on the contextual information about the locale of the target structural feature and on contextual information about the locale of said each of the one or more matching point clouds.

14. The method of any one of the previous claims, comprising:
obtaining one or more additional target point clouds that represent the target structural feature, wherein the one or more additional target point clouds are differently sized from one another and from the target point cloud;
for each of the one or more additional target point clouds, supplying the global structural information and said each of the one or more additional target point clouds to the global registration process and producing therefrom one or more additional globally registered representations of the structure; and
for each of the one or more additional target point clouds, supplying the globally registered representation of the structure and said each of the one or more additional target point clouds to the local registration process and producing therefrom one or more additional sets of one or more matching point clouds.

15. A program means comprising program instructions that, when executed by one or more processors, carries out the method of any one of the previous claims.

16. A computer readable storage medium comprising the program means of claim 15.

17. A system for identifying a structural feature of a structure, the system comprising:
one or more nontransitory memories having stored therein program instructions; and
one or more processors configured to execute the program instructions,
wherein the program instructions are configured to cause the system to perform the method of any one of claims 1 through 14 when executed by the one or more processors.

18. A structural feature recognizer for use in computational engineering, wherein the structural feature recognizer is configured to identify a structural feature of a structure, wherein the structural feature recognizer comprises circuitry that comprises:
one or more memories having stored therein program instructions; and
one or more processors configured to execute the program instructions,
wherein the circuitry is configured to cause the structural feature recognizer to perform the method of any one of claims 1 through 14.

19. A computational engineering system comprising the structural feature recognizer of claim 18.

## Patentansprüche

1. Ein Verfahren zum Identifizieren eines Strukturmerkmals einer Struktur, wobei das Verfahren Folgendes beinhaltet:
Erhalten einer globalen Punktwolkendarstellung der Struktur;
Erhalten einer Zielpunktwolke, die ein Zielstrukturmerkmal darstellt, wobei die Zielpunktwolke eine Teilmenge der globalen Punktwolkendarstellung der Struktur ist; Bereitstellen globaler Strukturinformationen und der Zielpunktwolke an einen globalen Registrierungsprozess und Erzeugen einer global registrierten Darstellung der Struktur daraus, wobei die globalen Strukturinformationen von der globalen Punktwolkendarstellung der Struktur abgeleitet werden; und
Bereitstellen der global registrierten Darstellung der Struktur und der Zielpunktwolke an einen lokalen Registrierungsprozess und Erzeugen einer oder mehrerer übereinstimmender Punktwolken daraus, wobei jede der einen oder mehreren übereinstimmenden Punktwolken eine Teilmenge der globalen Punktwolkendarstellung der Struktur ist.

2. Verfahren gemäß Anspruch 1, wobei die globalen Strukturinformationen die globale Punktwolkendarstellung der Struktur sind.

3. Verfahren gemäß Anspruch 1, das Folgendes beinhaltet:
Erzeugen eines Satzes von einem oder mehreren extrahierten Strukturmerkmalen basierend auf der globalen Punktwolkendarstellung der Struktur, wobei jedes des einen oder der mehreren extrahierten Strukturmerkmale eine poseninvariante Charakterisierung einer lokalen Geometrie um einen Punkt in der globalen Punktwolkendarstellung der Struktur ist,
wobei die globalen Strukturinformationen der Satz von einem oder mehreren extrahierten Strukturmerkmalen sind.

4. Verfahren gemäß Anspruch 3, wobei das Erzeugen des Satzes von einem oder mehreren extrahierten Strukturmerkmalen basierend auf der globalen Punktwolkendarstellung der Struktur Folgendes beinhaltet:
Bestimmen eines Punktmerkmalshistogramms (PFH) basierend auf der globalen Punktwolkendarstellung der Struktur.

5. Verfahren gemäß Anspruch 3, wobei das Erzeugen des Satzes von einem oder mehreren extrahierten Strukturmerkmalen basierend auf der globalen Punktwolkendarstellung der Struktur Folgendes beinhaltet:
Bestimmen eines Schnellpunktmerkmalshistogramms (FPFH) basierend auf der globalen Punktwolkendarstellung der Struktur.

6. Verfahren gemäß Anspruch 3, das Folgendes beinhaltet:
Downsampling der globalen Punktwolkendarstellung der Struktur, um eine downgesampelte globale Punktwolkendarstellung der Struktur zu erzeugen,
wobei das Erzeugen des Satzes von einem oder mehreren extrahierten Strukturmerkmalen basierend auf der globalen Punktwolkendarstellung der Struktur Folgendes beinhaltet:
Erzeugen des Satzes von einem oder mehreren extrahierten Strukturmerkmalen aus der downgesampelten globalen Punktwolkendarstellung der Struktur.

7. Verfahren gemäß einem der vorhergehenden Ansprüche, wobei das Erzeugen der einen oder der mehreren übereinstimmenden Punktwolken Folgendes beinhaltet: Identifizieren einer Teilmenge einer lokal registrierten Darstellung der Struktur als eine der einen oder mehreren übereinstimmenden Punktwolken, wenn ein Vergleich zwischen der Teilmenge der lokal registrierten Darstellung der Struktur und dem Zielstrukturmerkmal ein vordefiniertes Vergleichsergebnis erzeugt.

8. Verfahren gemäß Anspruch 7, wobei das vordefinierte Vergleichsergebnis eine vordefinierter Quadratwurzel des mittleren quadratischen Fehlers zwischen der Teilmenge der lokal registrierten Darstellung der Struktur und dem Zielstrukturmerkmal ist.

9. Verfahren gemäß einem der vorhergehenden Ansprüche, wobei der globale Registrierungsprozess ein RANdom-Sample-Consensus(RANSAC)-Prozess ist.

10. Verfahren gemäß einem der vorhergehenden Ansprüche, wobei der lokale Registrierungsprozess das Bestimmen eines Werts eines iterativen nächstgelegenen Punkts (ICP) beinhaltet.

11. Verfahren gemäß einem der vorhergehenden Ansprüche, wobei das Erhalten der globalen Punktwolkendarstellung der Struktur eines oder mehrere der Folgenden beinhaltet:
Erhalten von Punktwolkendaten durch Umwandeln einer geometrischen CAD-Darstellung der Struktur;
Erhalten von Punktwolkendaten durch Umwandeln einer
Formdiskretisierungsdarstellung der Struktur;
Erhalten von Punktwolkendaten durch Umwandeln einer Oberflächennetzdarstellung der Struktur;
Erhalten von Punktwolkendaten durch Umwandeln einer Volumennetzdarstellung der Struktur;
Erhalten von Punktwolkendaten durch Umwandeln von Sensordaten, die während eines Flugtests der Struktur gesammelt wurden; und
Erhalten von Punktwolkendaten durch Umwandeln von Sensordaten, die während eines physikalischen Tests der Struktur gesammelt wurden.

12. Verfahren gemäß einem der Ansprüche 1-10, wobei das Erhalten der globalen Punktwolkendarstellung der Struktur Folgendes beinhaltet:
Erhalten der Punktwolkendaten durch Umwandeln einer globalen Nicht-Punktwolkendarstellung der Struktur in die globale Punktwolkendarstellung der Struktur.

13. Verfahren gemäß einem der vorhergehenden Ansprüche, das Folgendes beinhaltet:
Erhalten einer Regel, die ein Volumen beschreibt, das mit dem Zielstrukturmerkmal assoziiert ist;
Erhalten von Kontextinformationen über einen Ort des Zielstrukturmerkmals; und Erzeugen, für jede der einen oder mehreren übereinstimmenden Punktwolken, eines entsprechenden Volumens mit einem Netzabstand, einer Größe und einer Pose,
wobei:
der Netzabstand gemäß der Regel erzeugt wird; und
die Größe und die Pose jeweils basierend auf den Kontextinformationen über den Ort des Zielstrukturmerkmals und auf Kontextinformationen über den Ort jeder der einen oder mehreren übereinstimmenden Punktwolken erzeugt werden.

14. Verfahren gemäß einem der vorhergehenden Ansprüche, das Folgendes beinhaltet:
Erhalten einer oder mehrerer zusätzlicher Zielpunktwolken, die das Zielstrukturmerkmal darstellen, wobei die eine oder die mehreren zusätzlichen Zielpunktwolken im Vergleich zueinander und zu der Zielpunktwolke unterschiedlich groß sind;
für jede der einen oder mehreren zusätzlichen Zielpunktwolken, Bereitstellen der globalen Strukturinformationen und jeder der einen oder der mehreren zusätzlichen Zielpunktwolken an den globalen Registrierungsprozess und Erzeugen einer oder mehrerer zusätzlicher global registrierter Darstellungen der Struktur daraus; und
für jede der einen oder mehreren zusätzlichen Zielpunktwolken, Bereitstellen der global registrierten Darstellung der Struktur und jeder der einen oder mehreren zusätzlichen Zielpunktwolken an den lokalen Registrierungsprozess und Erzeugen eines oder mehrerer zusätzlicher Sätze von einer oder mehreren übereinstimmenden Punktwolken daraus.

15. Ein Programmmittel, das Programmanweisungen beinhaltet, die, wenn sie von einem oder mehreren Prozessoren ausgeführt werden, das Verfahren gemäß einem der vorhergehenden Ansprüche ausführen.

16. Ein computerlesbares Speichermedium, das das Programmmittel gemäß Anspruch 15 beinhaltet.

17. Ein System zum Identifizieren eines Strukturmerkmals einer Struktur, wobei das System Folgendes beinhaltet:
einen oder mehrere nichtflüchtige Speicher, in denen Programmanweisungen gespeichert sind; und
einen oder mehrere Prozessoren, die konfiguriert sind, um die Programmanweisungen auszuführen,
wobei die Programmanweisungen konfiguriert sind, um das System zu veranlassen, das Verfahren gemäß einem der Ansprüche 1 bis 14 durchzuführen, wenn sie von dem einen oder den mehreren Prozessoren ausgeführt werden.

18. Ein Strukturmerkmalerkenner zur Verwendung in der Computertechnik, wobei der Strukturmerkmalerkenner konfiguriert ist, um ein Strukturmerkmal einer Struktur zu identifizieren,
wobei der Strukturmerkmalerkenner eine Schaltung beinhaltet, die Folgendes beinhaltet:
einen oder mehrere Speicher, in denen Programmanweisungen gespeichert sind; und einen oder mehrere Prozessoren, die konfiguriert sind, um die Programmanweisungen auszuführen,
wobei die Schaltung konfiguriert ist, um den Strukturmerkmalerkenner zu veranlassen, das Verfahren gemäß einem der Ansprüche 1 bis 14 durchzuführen.

19. Ein Computertechniksystem, das den Strukturmerkmalerkenner gemäß Anspruch 18 beinhaltet.

## Revendications

1. Un procédé d'identification d'une caractéristique structurelle d'une structure, le procédé comprenant :
l'obtention d'une représentation globale de nuage de points de la structure ;
l'obtention d'un nuage de points cible qui représente une caractéristique structurelle cible, le nuage de points cible étant un sous-ensemble de la représentation globale de nuage de points de la structure ;
la fourniture d'informations structurelles globales et du nuage de points cible à un processus d'enregistrement global et la production à partir de ceux-ci d'une représentation globalement enregistrée de la structure, les informations structurelles globales étant dérivées de la représentation globale de nuage de points de la structure ; et
la fourniture de la représentation globalement enregistrée de la structure et du nuage de points cible à un processus d'enregistrement local et la production à partir de ceux-ci d'un ou de plusieurs nuages de points concordants, chacun des un ou plusieurs nuages de points concordants étant un sous-ensemble de la représentation globale de nuage de points de la structure.

2. Le procédé de la revendication 1, dans lequel les informations structurelles globales sont la représentation globale de nuage de points de la structure.

3. Le procédé de la revendication 1, comprenant :
la production d'un ensemble d'une ou de plusieurs caractéristiques structurelles extraites sur la base de la représentation globale de nuage de points de la structure,
chacune des une ou plusieurs caractéristiques structurelles extraites étant une caractérisation invariante à la pose d'une géométrie locale autour d'un point dans la représentation globale de nuage de points de la structure,
dans lequel les informations structurelles globales sont l'ensemble d'une ou de plusieurs caractéristiques structurelles extraites.

4. Le procédé de la revendication 3, dans lequel la production de l'ensemble d'une ou de plusieurs caractéristiques structurelles extraites sur la base de la représentation globale de nuage de points de la structure comprend :
la détermination d'un histogramme de caractéristiques ponctuelles (PFH, *Point Feature Histogram*) sur la base de la représentation globale de nuage de points de la structure.

5. Le procédé de la revendication 3, dans lequel la production de l'ensemble d'une ou de plusieurs caractéristiques structurelles extraites sur la base de la représentation globale de nuage de points de la structure comprend :
la détermination d'un histogramme de caractéristiques ponctuelles rapide (FPFH, *Fast Point Feature Histogram*) sur la base de la représentation globale de nuage de points de la structure.

6. Le procédé de la revendication 3, comprenant :
le sous-échantillonnage de la représentation globale de nuage de points de la structure pour produire une représentation globale sous-échantillonnée de nuage de points de la structure,
dans lequel la production de l'ensemble d'une ou de plusieurs caractéristiques structurelles extraites sur la base de la représentation globale de nuage de points de la structure comprend :
la production de l'ensemble d'une ou de plusieurs caractéristiques structurelles extraites à partir de la représentation globale sous-échantillonnée de nuage de points de la structure.

7. Le procédé de l'une quelconque des revendications précédentes, dans lequel la production des un ou plusieurs nuages de points concordants comprend :
l'identification d'un sous-ensemble d'une représentation enregistrée localement de la structure comme étant l'un des un ou plusieurs nuages de points concordants lorsqu'une comparaison entre le sous-ensemble de la représentation enregistrée localement de la structure et la caractéristique structurelle cible produit un résultat de comparaison prédéfini.

8. Le procédé de la revendication 7, dans lequel le résultat de comparaison prédéfini est une erreur quadratique moyenne prédéfinie entre le sous-ensemble de la représentation enregistrée localement de la structure et la caractéristique structurelle cible.

9. Le procédé de l'une quelconque des revendications précédentes, dans lequel le processus d'enregistrement global est un processus *RANdom SAmple Consensus* (RANSAC).

10. Le procédé de l'une quelconque des revendications précédentes, dans lequel le processus d'enregistrement local comprend la détermination d'une valeur de point le plus proche itératif (ICP, *Iterative Closest Point*).

11. Le procédé de l'une quelconque des revendications précédentes, dans lequel l'obtention de la représentation globale de nuage de points de la structure comprend une ou plusieurs actions parmi :
l'obtention de données de nuage de points par conversion d'une représentation géométrique CAD de la structure ;
l'obtention de données de nuage de points par conversion d'une représentation de discrétisation de forme de la structure ;
l'obtention de données de nuage de points par conversion d'une représentation de maillage de surface de la structure ;
l'obtention de données de nuage de points par conversion d'une représentation de maillage de volume de la structure ;
l'obtention de données de nuage de points par conversion de données de capteur collectées au cours d'un essai en vol de la structure ; et
l'obtention de données de nuage de points par conversion de données de capteur collectées au cours d'un essai physique de la structure.

12. Le procédé de l'une quelconque des revendications 1 à 10, dans lequel l'obtention de la représentation globale de nuage de points de la structure comprend :
l'obtention des données de nuage de points par conversion d'une représentation globale non nuage de points de la structure en la représentation globale de nuage de points de la structure.

13. Le procédé de l'une quelconque des revendications précédentes, comprenant :
l'obtention d'une règle qui décrit un volume associé à la caractéristique structurelle cible ;
l'obtention d'informations contextuelles concernant un emplacement de la caractéristique structurelle cible ; et
la production, pour chacun des un ou plusieurs nuages de points concordants, d'un volume correspondant ayant un espacement de maillage, une taille, et une pose, dans lequel :
l'espacement de maillage est produit conformément à la règle ; et
la taille et la pose sont chacune produites sur la base des informations contextuelles concernant l'emplacement de la caractéristique structurelle cible et d'informations contextuelles concernant l'emplacement de chaque dit nuage des un ou plusieurs nuages de points concordants.

14. Le procédé de l'une quelconque des revendications précédentes, comprenant :
l'obtention d'un ou de plusieurs nuages de points cibles supplémentaires qui représentent la caractéristique structurelle cible, les un ou plusieurs nuages de points cibles supplémentaires étant dimensionnés différemment les uns des autres et du nuage de points cible ;
pour chacun des un ou plusieurs nuages de points cibles supplémentaires, la fourniture des informations structurelles globales et de chaque dit nuage des un ou plusieurs nuages de points cibles supplémentaires au processus d'enregistrement global et la production à partir de ceux-ci d'une ou de plusieurs représentations globalement enregistrées supplémentaires de la structure ; et
pour chacun des un ou plusieurs nuages de points cibles supplémentaires, la fourniture de la représentation globalement enregistrée de la structure et de chaque dit nuage des un ou plusieurs nuages de points cibles supplémentaires au processus d'enregistrement local et la production à partir de ceux-ci d'un ou de plusieurs ensembles supplémentaires d'un ou de plusieurs nuages de points concordants.

15. Un moyen de programme comprenant des instructions de programme qui, lorsqu'elles sont exécutées par un ou plusieurs processeurs, mettent en œuvre le procédé de l'une quelconque des revendications précédentes.

16. Un support de stockage lisible par ordinateur comprenant le moyen de programme de la revendication 15.

17. Un système pour l'identification d'une caractéristique structurelle d'une structure, le système comprenant :
une ou plusieurs mémoires non transitoires dans lesquelles sont stockées des instructions de programme ; et
un ou plusieurs processeurs configurés pour exécuter les instructions de programme, dans lequel les instructions de programme sont configurées pour amener le système à effectuer le procédé de l'une quelconque des revendications 1 à 14 lorsqu'elles sont exécutées par les un ou plusieurs processeurs.

18. Un dispositif de reconnaissance de caractéristique structurelle destiné à être utilisé en ingénierie informatique, le dispositif de reconnaissance de caractéristique structurelle étant configuré pour identifier une caractéristique structurelle d'une structure,
le dispositif de reconnaissance de caractéristique structurelle comprenant une circuiterie qui comprend :
une ou plusieurs mémoires dans lesquelles sont stockées des instructions de programme ; et
un ou plusieurs processeurs configurés pour exécuter les instructions de programme, dans lequel la circuiterie est configurée pour amener le dispositif de reconnaissance de caractéristique structurelle à effectuer le procédé de l'une quelconque des revendications 1 à 14.

19. Un système d'ingénierie informatique comprenant le dispositif de reconnaissance de caractéristique structurelle de la revendication 18.
